# EUROPÄISCHE PATENTSCHRIFT

(11) **EP 1 503 426 B1**
(45) Veröffentlichungstag und Bekanntmachung des Hinweises auf die Patenterteilung: **02.02.2011**
(21) Anmeldenummer: 04014478.4
(22) Anmeldetag: 21.06.2004
(51) Int. Cl.: H01L 31/05, H01R 13/24

(54) **Anschlusseinrichtung für ein Solarstrommodul**
Junction box for a solar cell module
Boite de jonction pour un module de cellule solaire

(30) Priorität: 31.07.2003 DE 10334935
(43) Veröffentlichungstag der Anmeldung: 02.02.2005
(73) Patentinhaber: Harting Electric GmbH & Co. KG, 32339 Espelkamp (DE)
(72) Erfinder: Nass, Andreas, 31606 Warmsen (DE); Post, Dirk-Peter, 32312 Lübbecke (DE); Schmidt, Martin, 32312 Lübbecke (DE); Sorig, Ludger, 59387 Ascheberg (DE); Stein, Hartwig, 86937 Scheuring (DE)

(56) Entgegenhaltungen:
- EP-A- 1 006 593
- FR-A- 2 362 494
- US-A- 4 830 038
- US-A- 5 503 684
- US-A- 5 513 075
- US-A1- 2004 047 118
- US-B1- 6 582 249

## Beschreibung

Die Erfindung betrifft eine Anschlusseinrichtung in einem Anschlussgehäuse für ein Solarstrommodul zur Verbindung einer elektrischen Anschlussleitung mit elektrischen Verbindungsleitern des Solarstrommoduls, die innerhalb eines transluciden Scheibenverbundes angeordnet sind und mehrere photovoltaische Solarelemente miteinander elektrisch verbinden.

Eine derartige Anschlusseinrichtung wird benötigt, um den durch photovoltaische Solarelemente in einem Solarstrommodul erzeugten Solarstrom, zur weiteren Verwertung für einen Verbraucher mittels eines Verbindungskabels weiterleiten zu können.

Aus der EP 1 006 593 A1 ist ein photovoltaisches Solarmodul in Plattenform bekannt, mit einer Außenplatte und einer Innenplatte und einer Kunststoffschicht in der Solarzellen eingebettet sind. Dabei ist eine Anschlusseinrichtung vorgesehen, die einen Steckverbinder umfasst, der in einer Öffnung in der Innenplatte angeordnet ist, und dauerhaft mit mehreren Verbindungsleitern der Solarzellen verbunden ist.

Nachteilig wirkt sich dabei aus, dass eine derartige dauerhafte Verbindung gelötet oder geschweißt sein muss und somit recht aufwendig und teuer zu realisieren ist.

Aus US5503684 geht eine Anschlußeinrichtung und Anschlußgehäuse für ein Solarmodul hervor, wobei das Solarmodul als transparenter Scheibenverbund ausgebildet ist. Durch eine Öffnung in einer Scheibe des Solarmoduls wird ein Verbindungsleiter innerhalb des Scheibenverbundes mit einem metallischen Federelement kontaktiert und dadurch mit weiteren elektrisch leitenden Elementen in dem Anschlußgehäuse elektrisch verbunden.

Der Erfindung liegt daher die Aufgabe zugrunde, eine Anschlusseinrichtung der eingangs genannten Art dahingehend auszubilden, eine einfach und kostengünstig herzustellende und ohne Werkzeug zu realisierende, lösbare elektrische Verbindung zwischen den Verbindungsleitern der Solarmodule und weiterführenden elektrischen Leitungen herzustellen.

Diese Aufgabe wird dadurch gelöst, dass die Enden der Verbindungsleiter teilweise von einem Versteifungselement unterstützt sind, und dass die Verbindungsleiter im Bereich der Unterstützung des Versteifungselementes mit jeweils einem Kontaktstift kontaktierbar sind.

Vorteilhafte Ausgestaltungen der Erfindung sind in den Ansprüchen 2-10 angegeben.

Die mit der Erfindung erzielten Vorteile bestehen insbesondere darin, dass Kontaktstifte mit einer pyramidenförmigen Oberflächenstruktur vorgesehen sind, die einen direkten und gasdichten Kontakt zu den flachen elektrischen Verbindungsleitern innerhalb eines Solarmoduls ermöglichen, mit denen die einzelnen photovoltaischen Solarelemente - eingebettet in einem Scheibenverbund - miteinander elektrisch verbunden sind.
Da die aus Kupfer gefertigten Verbindungsleiter für eine durch Druck erzeugte Verbindungsart relativ weich sind, sind die Verbindungsleiter mit einem Versteifungselement unterlegt, so dass die Verbindungsleiter, die zudem noch in einer ebenfalls relativ weichen Kunststoffschicht im Scheibenverbund eingelegt sind, einen entsprechenden Gegendruck zu den Kontaktstiften ausbilden.
Dabei ist von besonderem Vorteil, dass die Kontaktstifte an einem Federelement gehalten sind und somit auch einen stetigen Druck gegen die Verbindungsleiter aufrechterhalten, so dass erhöhte Übergangswiderstände vermieden werden.
An den Versteifungselementen sind weiterhin Rastmittel vorgesehen, die mit Rastmitteln einer isolierenden Kontaktplatte in Eingriff stehen.
Die Kontaktplatte ist mit einer angeformten Grundplatte versehen, die zwischen den Scheiben gehalten ist, wobei ein kragenförmiges Anschlussteil der Kontaktplatte innerhalb einer Ausnehmung einer der Scheiben eine Verbindung mit einem Anschlussgehäuse ermöglicht, das auf die Ausnehmung der Scheibe aufgesetzt wird. Dabei werden die vorteilhafterweise federnd in dem Anschlussgehäuse gehaltenen Kontaktstifte gegen die Verbindungsleiter im Scheibenverbund gedrückt.
Da die Kontaktplatte innerhalb des Scheibenverbundes maximal die Höhe der äußeren Scheibe aufweist, also diese nicht überragt, können vorteilhafter mehrere Scheiben mit Solarstrommodulen für die Lagerung oder einen Transport direkt aufeinandergestapelt werden, da zur Abdeckung der Ausnehmung zunächst lediglich eine Schutzkappe gegen Schmutz und dergleichen vorgesehen ist, die nach der Montage des Solarstrommoduls entfernt wird und durch das Anschlussgehäuse ersetzt wird.
Vorzugsweise ist die Gesamthöhe der Kontaktplatte jedoch niedriger vorgesehen, um das Anschlussgehäuse mit einem daran angefügten Kragen für eine polarisierte Aufnahme in der Ausnehmung im Scheibenverbund einzufügen.
Die Kontaktstifte sind wiederum elektrisch leitend mit einer im Anschlussgehäuse vorgesehenen Leiterplatte verbunden, von der eine elektrische Verbindung zu einem Anschlussstecker vorgesehen ist, der vorteilhafterweise einen werkzeugloser Schnellanschluss mit einem externen Verbindungskabel aufweist und hier in Form einer Käfigzugfeder ausgeführt ist.
Dabei ist das Anschlussgehäuse mit den Kontaktstiften vorteilhafterweise in einer spritzwasser- und staubdichten Version vorgesehen, um unabhängig von Umwelteinflüssen eine sichere elektrische Verbindung zwischen den Solarelementen und einem Verbraucher zu realisieren.

Ein Ausführungsbeispiel der Erfindung ist in der Zeichnung dargestellt und wird im folgenden näher erläutert. Es zeigen:
- Fig. 1: die Montage einer Kontaktplatte in einem Scheibenverbund eines Solarstrommoduls,
- Fig. 2: eine Detaildarstellung der Kontaktplatte,
- Fig. 3: eine Kontaktplatte fertig montiert im Scheibenverbund,
- Fig. 4: eine auseinandergezogene Darstellung des Kontaktgehäuses,
- Fig. 5: ein auf einer Leiterplatte montiertes Kontaktgehäuse mit Kontaktstiften,
- Fig. 6: eine auseinandergezogene Darstellung des Anschlussgehäuses,
- Fig. 7: eine Bodenansicht des Anschlussgehäuses,
- Fig. 8: eine Montageansicht des Anschlussgehäuses auf dem Scheibenverbund, und
- Fig. 9: eine Schnittdarstellung durch das Anschlussgehäuse mit einem Anschlussstecker.

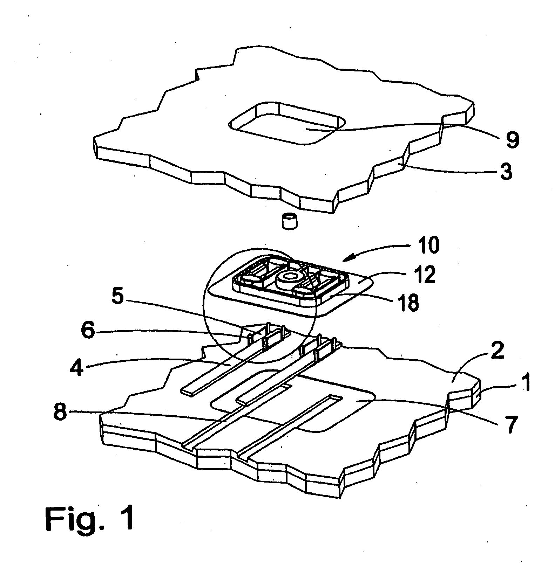

In der Fig.1 ist ein translucider Scheibenverbund eines Solarstrommoduls bestehend aus zwei Scheiben, einer Außenscheibe 1 und einer Innenscheibe 3 gezeigt, zwischen denen eine Kunststoffschicht 2 eingelagert ist, in der photovoltaischen Solarelemente (hier nicht gezeigt) eingebettet sind.
Von den Solarelementen sind flache Verbindungsleiter 4 zu einem zentralen Übergabepunkt geführt, an dem eine als flaches Gehäuseteil ausgebildete Kontaktplatte 10 angeordnet ist.
Die Verbindungsleiter 4 sind in Leiterkanälen 8 in der Kunststoffschicht 2 eingelegt und an ihren Enden von teilweise umgreifenden Versteifungselementen 5 umgeben.
Die Kontaktplatte 10 ist als flaches, rechteckiges Formteil ausgeführt und weist eine Grundplatte 12 auf, auf der eine Struktur verschiedener Formgebungen vorgesehen ist, die von einem Kragen 18 umgeben ist.
Die Kontaktplatte wird oberhalb der Verbindungsleiter 4 in einer der Grundplatte entsprechenden Ausformung 7 auf der Kunststoffschicht 2 aufgelegt, wobei an den Versteifungselementen 5 vorgesehene Rastmittel 6 in der Kontaktplatte je an einem Hinterschnitt 16 verrasten.

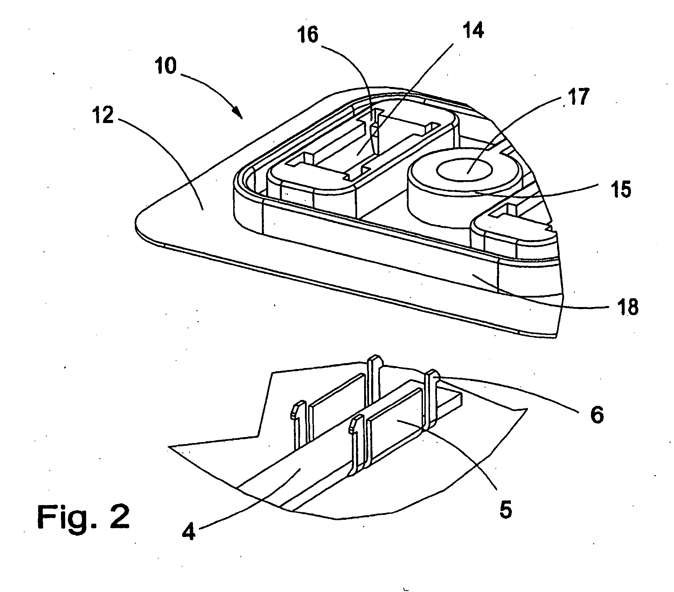

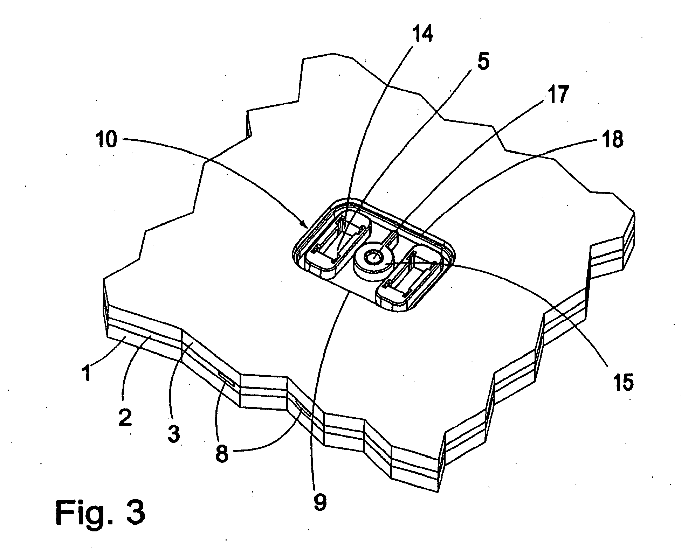

In der Fig. 2 ist in einem vergrößerten Ausschnitt aus der Fig. 1 ersichtlich, wie ein Versteifungselement 5 in eine rechteckig ausgeführte Ausnehmung 14 der Kontaktplatte 10 einfügbar ist und die dreiseitig freigeschnittenen Rasthaken 6 an je einem Hinterschnitt 16 verrastbar sind. Dabei sind zwei Ausnehmungen 14 zum Anschluss von zwei Verbindungsleitern 4 vorgesehen. Weiterhin ist eine Polarisationsform 15, die als Kreisring mit einem daran angesetzten Steg ausgebildet, in deren Zentrum einer Gewindebohrung 17 vorgesehen ist. (siehe auch Fig. 3)

Nach dem Aufsetzen der oberen Scheibe 3 mit der Ausnehmung 9 passgenau auf den Bereich in dem die Kontaktplatte 10 auf der Kunststoffschicht 2 fixiert ist, ist der Scheibenverbund fertig montiert.
Als Schutz gegen ein Eindringen von Schmutz bei einem Transport des Scheibenverbundes, kann die Ausnehmung mit einem Schutzdeckel o. ä. abgedeckt werden, wobei gewährleistet ist, dass die maximale Höhe der Kontaktplatte 10 die Scheibendicke nicht überschreitet. Normalerweise ist die Höhe des Kragens kürzer als die Dicke der Scheibe 3 des Scheibenverbundes

In der Fig. 3 ist ein fertig montierter Scheibenverbund mit einer Sicht auf die Kontaktplatte 10 gezeigt. Dabei sind die rechteckigen Ausnehmungen 14 erkennbar in denen die Versteifungselemente 5 verrastet sind, sowie die Polarisation 15 mit der zentralen Gewindebohrung 17. Die Polarisation ist als Kreisring mit einem angefügten schmalen Steg ausgeführt, so dass ein später aufzusteckendes Anschlussgehäuse mit einer entsprechend negativ geformten Polarisation nur in einer Position gesteckt werden kann.

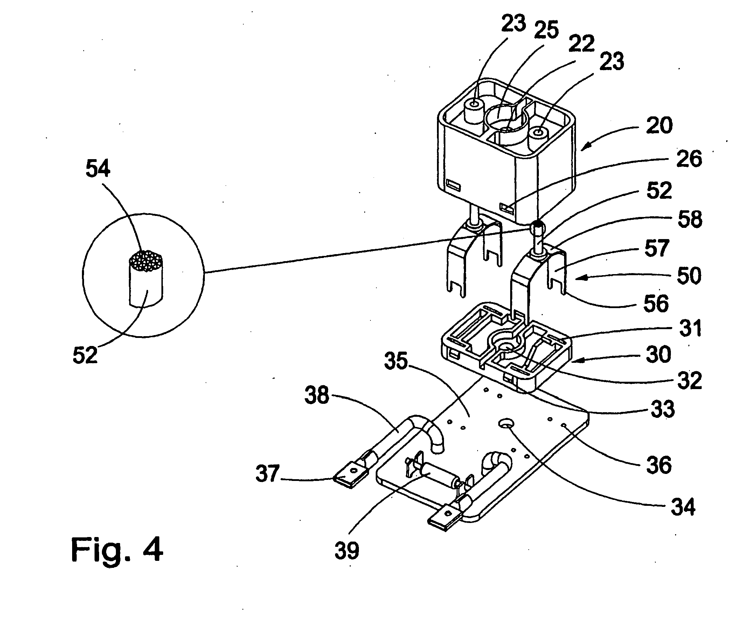

Die Fig. 4 zeigt in einer auseinandergezogenen Darstellung ein Kontaktgehäuse 20 in dem Kontaktelemente 50 gehalten sind, sowie eine Deckelplatte 30 zum Verschließen des Kontaktgehäuses und eine Leiterplatine 35.
Das Kontaktelement 50 besteht aus einem U-förmig ausgebildeten Federelement 57 auf dessen Bogenabschnitt 58 ein Kontaktstift 52 fixiert ist.

Die Kontaktfläche 54 ist mit pyramidenförmigen Spitzen versehen, die bei der Endmontage direkt auf die flachen Verbindungsleiter 4 aufsetzen und den Strom der Solarelemente zu einem Verbraucher aufnehmen.
Die Anschlussenden der Federelemente 57 sind als stiftförmige Anschlussenden 56 ausgeführt und werden in Bohrungen 36 auf der Leiterplatte 35 eingesetzt und verlötet.
Zur Fixierung sind die Schenkel der Federelemente in Längsschlitzen 31 der Deckelplatte 30 geführt, während der Kontaktstift 52 in einer Führungsbohrung 23 im Kontaktgehäuse 20 gehalten ist.
Zwischen den beiden Führungsbohrungen 23 ist in dem Kontaktgehäuse 20 eine negative Polarisationsform 25 zu der in der Kontaktplatte 10 vorgesehenen Polarisation 15 eingeformt, die nur ein korrektes Aufsetzen des Kontaktgehäuses mit den Kontaktelementen 50 auf die Kontaktplatte 10 im Scheibenverbund 1, 2, 3 zulässt.
An der Deckelplatte 30 sind weiterhin nach außen weisende Rasthaken 33 vorgesehen, die bei einer Montage des Kontaktgehäuses 20 mit der Deckelplatte 30, in Rastöffnungen 26 im Kontaktgehäuse 20 eingreifen, so dass das Kontaktgehäuse 20 mit dem Kontaktelement 50 und der Deckelplatte 30 auf der Leiterplatte 35 eine Einheit bilden.
Durch das gesamte montierte Gebilde von Kontaktgehäuse 20, Deckelplatte 30 und Leiterplatte 35 ist eine Zentralbohrung vorgesehen, durch die bei der Montage des Anschlussgehäuses auf das Solarstrommodul eine Schraube 43 durch die Bohrungen 34, 32, 22 von Leiterplatte 35, Deckelplatte 30 und Kontaktgehäuse 20 geführt ist.

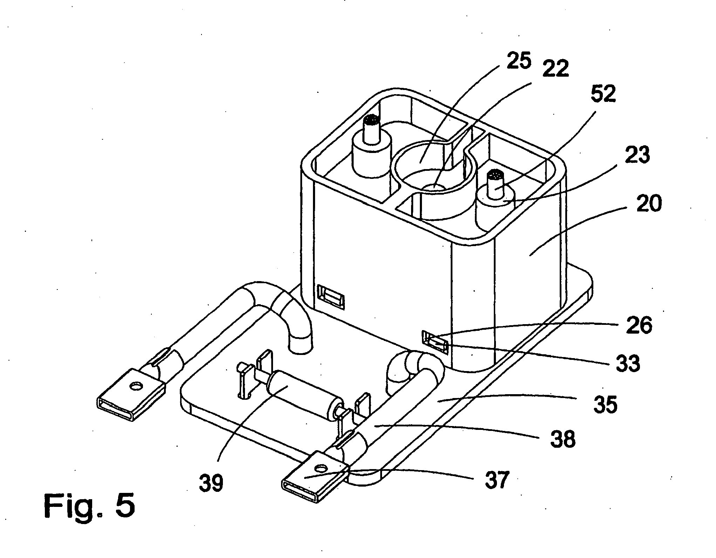

In der Fig. 5 ist ein zusammengefügtes, verrastetes Gehäuse 20 montiert auf der Leiterplatte 35 dargestellt. Dabei ragen die Kontaktelemente mit den Kontaktstiften 52 aus dem Kontaktgehäuse hervor, wobei beide Elemente aufgrund der federnden Eigenschaft des U-förmigen Federelementes 57 unabhängig voneinander in ihren Führungsbohrungen 23 axial gleiten können. Weiterhin sind auf der Leiterplatte Verbindungskabel 38 vorgesehen, die mit Anschlusskontakten 37 versehen sind. Zusätzlich können Bauelemente 39 auf der Leiterplatte vorgesehen sein.

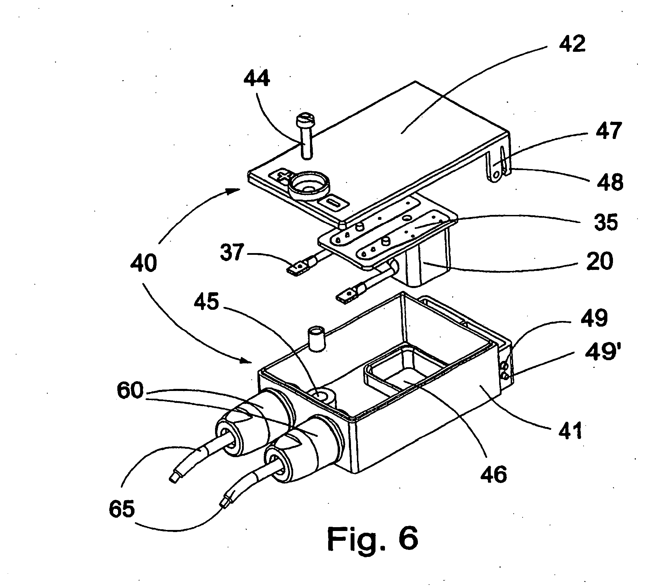

Die Fig. 6 zeigt ein rechteckig ausgeführtes Anschlussgehäuse 40 im auseinandergezogenen Zustand, bestehend aus einem Gehäuseunterteil 41 und einer aufklappbaren Gehäuseabdeckung 42.
Die Gehäuseabdeckung 42 ist mit den Schenkeln 47 an den Stiften 49 drehbar gehalten, während der Schenkel 48 in Zusammenspiel mit dem Stift 49' im geöffneten Zustand eine Einrastposition der Abdeckung bewirkt.
Das Gehäuseunterteil weist eine Öffnung 46 auf, in die das Kontaktgehäuse 20 mit der Leiterplatte 35 einzusetzen ist, während die Anschlusskontakte 37 mit den Anschlusssteckern 60 zu verbinden sind.
Das Gehäuseunterteil und die Gehäuseabdeckung sind mittels einer Schraube 44, die in einer Gewindebohrung 45 einschraubbar ist, sowie einer nicht weiter gezeigten umlaufenden Dichtung zwischen Gehäuse und Abdeckung dicht zu verschließen, und so weitestgehend gegen Umwelteinflüsse geschützt.

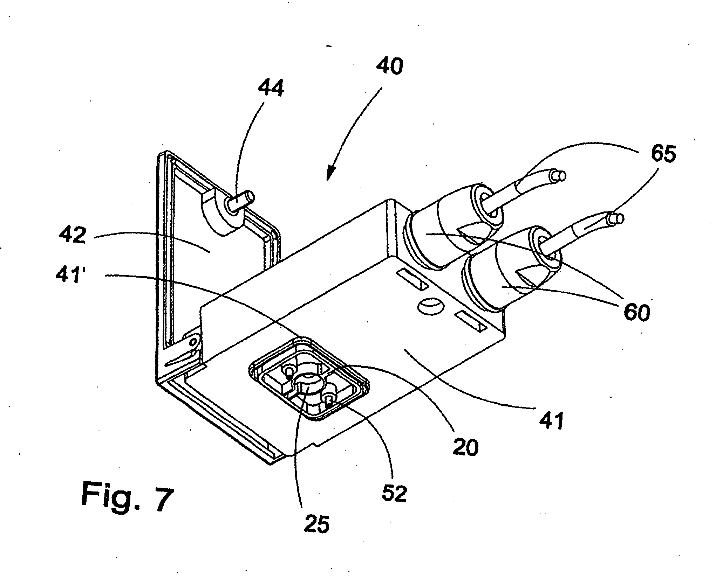

In der Fig. 7 ist das Anschlussgehäuse 40 aus der Sicht von "unten" - gleichzeitig die Montageseite - gezeigt, mit der es auf die Kontaktplatte 10 im Scheibenverbund aufgesetzt wird. Dabei ist zu erkennen, dass das Kontaktgehäuse 20 aus dem Boden des Anschlussgehäuses hervorragt. Und zwar noch gegenüber einem im Boden angeformten Kragen 41'. Der Kragen polarisiert das Anschlussgehäuse in der Ausnehmung 9 der oberen Scheibe 3, während die Wandung des Kontaktgehäuses innerhalb des Kragens 18 an der Kontaktplatte zentriert wird.

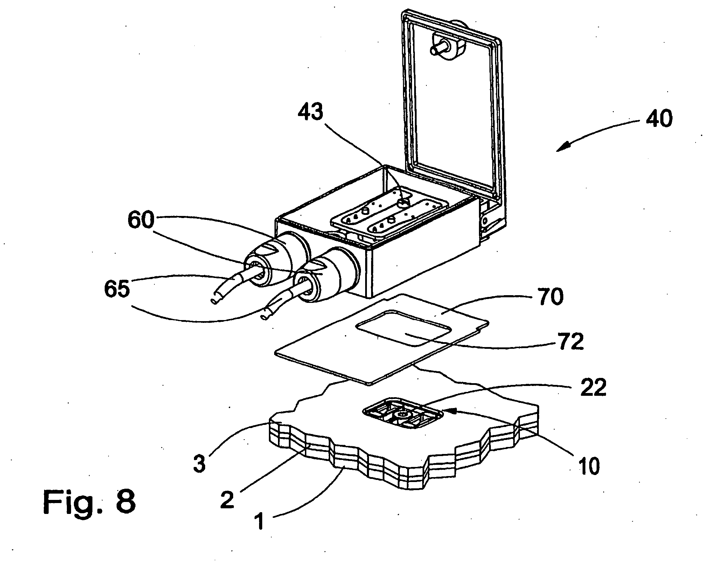

Die Montage des Anschlussgehäuses ist in der Fig. 8 gezeigt. Dabei wird auf der Bodenseite des Gehäuseunterteiles 41 zunächst eine doppelseitige Klebefolie 70 mit einer Ausnehmung 72, für den Bereich in dem der Kragen 41' aus dem Gehäuseunterteil hervorragt, aufgeklebt und anschließend das Anschlussgehäuse 40 auf den Bereich des Solarstrommoduls aufgesetzt, in dem die Kontaktplatte 10 im Scheibenverbund 1,2,3 fixiert ist.
Das Anschlussgehäuse 40 wird zunächst ohne das Kontaktgehäuse 20 auf den Scheibenverbund aufgesetzt. Erst danach erfolgt das Einsetzen des Kontaktgehäuses und das Verschrauben mittels der Verschraubung 43 an der Kontaktplatte 10.

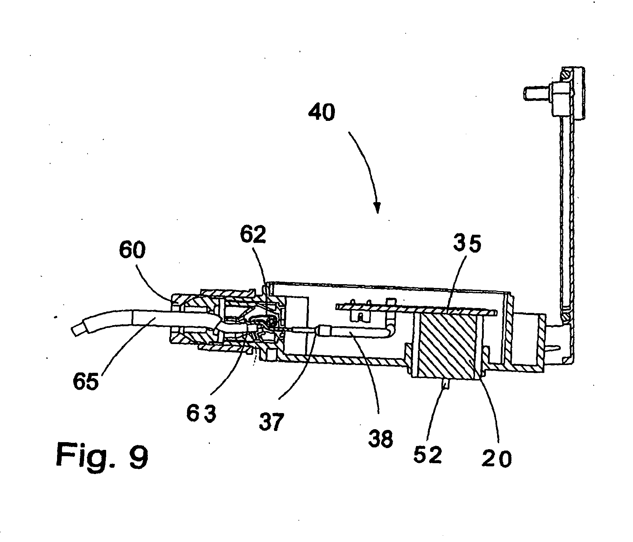

Die Fig. 9 zeigt einen Schnitt durch das geöffnete Anschlussgehäuse 40 in einem Bereich an dem einer der Anschlussstecker 60 an dem Anschlussgehäuse gesteckt ist.
So ist erkennbar wie die Stromabnahme über den herausragenden Kontaktstift 52 im Kontaktgehäuse 20 zu der Leiterplatte 35 über das Verbindungskabel 38, zu dem Anschlusskontakt 37 und zum Anschlussbereich 63 im Anschlussstecker 60 erfolgt, der hier mittels einer Käfigzugfeder 62 ausgeführt ist und weiter an die in der Käfigzugfeder fixierte Anschlussleitung 65 geleitet wird.
Anstelle der Käfigzugfeder kann auch eine Verbindung mit einem axialen Anschluss für Litzenleiter in dem Anschlussstecker 60 vorgesehen sein.

## Patentansprüche

1. Anschlusseinrichtung in einem Anschlussgehäuse (40) für ein Solarstrommodul zur Verbindung einer elektrischen Anschlussleitung (65) mit elektrischen Verbindungsleitern (4) des Solarstrommoduls, die innerhalb eines transluciden Scheibenverbundes (1, 2, 3) angeordnet sind und mehrere photovoltaische Solarelemente miteinander elektrisch verbinden,
**dadurch gekennzeichnet,**
**dass** jeweils ein Versteifungselement (5) zur teilweisen Unterstützung eines Endes jedes Verbindungsleiters (4) vorgesehen ist, und dass jeweils ein Kontaktstift (52) zur Kontaktierung jedes Verbindungsleiters (4) im Bereich des jeweiligen Versteifungselementes (5) vorgesehen ist.

2. Anschlusseinrichtung nach Anspruch 1, **dadurch gekennzeichnet, dass** das Versteifungselement (5) U-förmig ausgebildet ist.

3. Anschlusseinrichtung nach Anspruch 1 oder 2, **dadurch gekennzeichnet,**
**dass** das Versteifungselement (5) mit Rastmitteln (6) versehen ist, die an einer Hinterschneidung (16) in einer Kontaktplatte (10) verrasten, wobei die Kontaktplatte (10) in einer Ausformung (7) der transluciden Kunststoffschicht (2) fixiert ist, die zwischen den Scheiben (1, 3) des Scheibenverbundes angeordnet ist.

4. Anschlusseinrichtung nach einem der vorstehenden Ansprüche, **dadurch gekennzeichnet,**
**dass** der Kontaktstift (52) eine Kontaktfläche (54) mit einer Vielzahl pyramidenförmiger Spitzen aufweist.

5. Anschlusseinrichtung nach einem der vorstehenden Ansprüche, **dadurch gekennzeichnet,**
**dass** der Kontaktstift (52) mittig und nach außen weisend auf einem Bogenabschnitt (58) eines U-förmig gebogenen Federelementes (57) angeordnet ist.

6. Anschlusseinrichtung nach einem der vorstehenden Ansprüche, **dadurch gekennzeichnet,**
**dass** das Federelement (57) zwei Anschlussenden (56) aufweist, die jeweils in einem Längsschlitz (31) einer Deckelplatte (30) geführt sind und mit einer Leiterplatte (35) elektrisch leitend verbunden sind.

7. Anschlusseinrichtung nach einem der vorstehenden Ansprüche, **dadurch gekennzeichnet,**
**dass** die Deckelplatte (30) mit einem Kontaktgehäuse (20) verrastbar ist, wobei die Kontaktstifte (52) des Kontaktelementes (50) im Kontaktgehäuse (20) innerhalb einer Durchgangsbohrung (23) geführt sind.

8. Anschlusseinrichtung nach einem der vorstehenden Ansprüche, **dadurch gekennzeichnet,**
**dass** das Kontaktgehäuse (20), mit den Kontaktelementen (50), der Deckelplatte (30), und der Leiterplatte (35) als Einheit zusammengefügt sind und in dem Anschlussgehäuse (40) in eine Ausnehmung (46) eintauchen und mittels einer Schraubverbindung 43 an der Kontaktplatte 10 im Scheibenverbund fixierbar ist.

9. Anschlusseinrichtung nach einem der vorstehenden Ansprüche, **dadurch gekennzeichnet,**
**dass** das Anschlüssgehäuse (40), die Kontaktplatte (10) in der Ausnehmung (9) abdeckend, mittels einer doppelseitigen Klebefolie (70) auf der Scheibe (3) des Scheibenverbundes (1, 2, 3) fixiert ist.

10. Anschlusseinrichtung nach einem der vorstehenden Ansprüche, **dadurch gekennzeichnet,**
**dass** an dem Anschlussgehäuse (40) Anschlussstecker (60) vorgesehen sind, so dass mittels je einer im Anschlussstecker angeordneten Käfigzugfeder (62), eine lösbare Verbindung zwischen der elektrischen Anschlussleitung (65) und den auf der Leiterplatte (35) im Anschlussgehäuse vorgesehenen Verbindungskabelstück (38) herstellbar ist.

## Claims

1. A connection device in a terminal housing (40) for a solar power module for connecting an electric connecting line (65) to electric connecting leads (4) of the solar power module which are arranged within a translucid composite pane arrangement (1, 2, 3) and electrically connect a plurality of photovoltaic solar cells with each other, **characterized in that**
one stiffening member (5) each is provided for partially supporting an end of each connecting lead (4), and **in that** one contact pin (52) each is provided for contacting each connecting lead (4) in the region of the respective stiffening member (5).

2. The connection device according to claim 1, **characterized in that**
the stiffening member (5) is of a U-shaped configuration.

3. The connection device according to claim 1 or 2, **characterized in that**
the stiffening member (5) is provided with locking means (6) which lock in place on an undercut (16) in a contact plate (10), the contact plate (10) being fixed in place in a shaped portion (7) of the translucid plastic layer (2) that is arranged between the panes (1, 3) of the composite pane arrangement.

4. The connection device according to any of the preceding claims, **characterized in that**
the contact pin (52) includes a contact surface (54) having a multitude of pyramidal tips.

5. The connection device according to any of the preceding claims, **characterized in that**
the contact pin (52) is arranged centrally and facing outwards on an arcuate section (58) of a spring member (57) bent in a U-shape.

6. The connection device according to any of the preceding claims, **characterized in that**
the spring member (57) includes two connecting ends (56) which are each guided in a longitudinal slot (31) of a cover plate (30) and are electrically conductively connected to a printed circuit board (35).

7. The connection device according to any of the preceding claims, **characterized in that**
the cover plate (30) is adapted to be locked with a contact housing (20), the contact pins (52) of the contact element (50) being guided within a through hole (23) in the contact housing (20).

8. The connection device according to any of the preceding claims, **characterized in that**
the contact housing (20) is joined together with the contact elements (50), the cover plate (30), and the printed circuit board (35) to form a unit, and dives into a recess (46) in the terminal housing (40), and is adapted to be fixed to the contact plate (10) in the composite pane arrangement by means of a screw connection (43).

9. The connection device according to any of the preceding claims, **characterized in that**
the terminal housing (40), covering the contact plate (10) in the recess (9), is fixed on the pane (3) of the composite pane arrangement (1, 2, 3) by means of a double-sided adhesive film (70).

10. The connection device according to any of the preceding claims, **characterized in that**
the terminal housing (40) has connector plugs (60) provided thereon, so that by means of one respective cage clamp (62) arranged in the connector plug, a releasable connection can be produced between the electric connecting line (65) and the connecting cable section (38) provided on the printed circuit board (35) in the terminal housing.

## Revendications

1. Dispositif de raccordement dans un boîtier de raccordement (40) pour un module de courant solaire pour relier une ligne de raccordement (65) avec des conducteurs de connexion électriques (4) du module de courant solaire qui sont agencés à l'intérieur d'un panneau composite (1, 2, 3) translucide et qui relient électriquement les uns aux autres plusieurs éléments solaires photovoltaïques.
**caractérisé en ce que**
un élément de renfort (5) respectif est prévu pour soutenir partiellement une extrémité de chaque conducteur de connexion (4), et **en ce qu'**une fiche de contact (52) respective est prévue pour mettre en contact chaque conducteur de connexion (4) dans la zone de l'élément de renfort (5) respectif.

2. Dispositif de raccordement selon la revendication 1, **caractérisé en ce que** l'élément de renfort (5) est réalisé en forme de U.

3. Dispositif de raccordement selon la revendication 1 ou 2, **caractérisé en ce que**
l'élément de renfort (5) est pourvu de moyens d'enclenchement (6) qui s'enclenchent sur une contre-dépouille (16) dans une plaque de contact (10), la plaque de contact (10) étant fixée dans une découpe (7) de la couche de matière plastique (2) translucide qui est agencée entre les panneaux (1, 3) du panneau composite.

4. Dispositif de raccordement selon l'une quelconque des revendications précédentes, **caractérisé en ce que**
la fiche de contact (52) présente une surface de contact (54) avec une multitude de pointes en forme de pyramides.

5. Dispositif de raccordement selon l'une quelconque des revendications précédentes, **caractérisé en ce que**
la fiche de contact (52) est agencée au milieu et tournée vers l'extérieur sur un tronçon en forme d'arc (58) d'un élément ressort (57) plié en forme de U.

6. Dispositif de raccordement selon l'une quelconque des revendications précédentes, **caractérisé en ce que**
l'élément ressort (57) présente deux extrémités de raccordement (56) qui sont chacune guidées dans une fente longitudinale (31) d'une plaque de couvercle (30) et qui sont connectées de manière électroconductrice avec une plaquette imprimée (35).

7. Dispositif de raccordement selon l'une quelconque des revendications précédentes, **caractérisé en ce que**
la plaque de couvercle (30) peut être enclenchée avec un boîtier de contact (20), les fiches de contact (52) de l'élément de contact (50) dans le boîtier de contact (20) étant guidées à l'intérieur d'un perçage traversant (23).

8. Dispositif de raccordement selon l'une quelconque des revendications précédentes, **caractérisé en ce que**
le boîtier de contact (20) est assemblé avec les éléments de contact (50), la plaque de couvercle (30) et la plaquette imprimée (35) pour former une unité et plonge dans un évidement (46) dans le boîtier de raccordement (40) et peut être fixé au moyen d'un vissage (43) sur la plaque de contact (10) dans le panneau composite.

9. Dispositif de raccordement selon l'une quelconque des revendications précédentes, **caractérisé en ce que**
le boîtier de raccordement (40), recouvrant la plaque de contact (10) dans l'évidement (9), est fixé au moyen d'une feuille collage (70) double sur le panneau (3) du panneau composite (1, 2, 3).

10. Dispositif de raccordement selon l'une quelconque des revendications précédentes, **caractérisé en ce que**
sur le boîtier de raccordement (40) sont prévues des fiches de raccordement (60) de telle sorte qu'au moyen d'un ressort de traction à cage (62) respectif, agencé dans la fiche de raccordement, une connexion amovible peut être réalisée entre la ligne de raccordement (65) électrique et la pièce de câble de connexion (38) prévue sur le boîtier de raccordement.
